(19) Europäisches Patentamt
European Patent Office
Office européen des brevets

(11) EP 2 172 505 B1

(12) # EUROPÄISCHE PATENTSCHRIFT

(45) Veröffentlichungstag und Bekanntmachung des Hinweises auf die Patenterteilung:
**07.09.2011 Patentblatt 2011/36**

(51) Int Cl.:
***C08G 18/67*** (2006.01) ***C08G 18/76*** (2006.01)
***C08G 18/77*** (2006.01) ***G03F 7/00*** (2006.01)
***G03F 7/027*** (2006.01) ***G11B 7/245*** (2006.01)

(21) Anmeldenummer: **09011958.7**

(22) Anmeldetag: **19.09.2009**

(54) **Photopolymerzusammensetzungen für optische Elemente und visuelle Darstellungen**

Photopolymer compounds for optical elements and visual representations

Compositions de photopolymères pour éléments optiques et représentations visuelles

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **01.10.2008 EP 08017275**

(43) Veröffentlichungstag der Anmeldung:
**07.04.2010 Patentblatt 2010/14**

(73) Patentinhaber: **Bayer MaterialScience AG**
**51368 Leverkusen (DE)**

(72) Erfinder:
- **Roelle, Thomas, Dr.**
  **51381 Leverkusen (DE)**
- **Bruder, Friedrich-Karl, Dr.**
  **47802 Krefeld (DE)**
- **Fäcke, Thomas, Dr.**
  **51375 Leverkusen (DE)**
- **Weiser, Marc-Stephan, Dr.**
  **51379 Leverkusen (DE)**
- **Hönel, Dennis**
  **53909 Zülpich (DE)**
- **Stoeckel, Nicolas, Dr.**
  **50733 Köln (DE)**

(56) Entgegenhaltungen:
**EP-A- 1 002 817**
**WO-A-2008/125199**
**US-A1- 2001 007 736**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 172 505 B1

**Beschreibung**

Die Erfindung betrifft neuartige Photopolymere auf Basis spezieller Urethanacrylate als Schreibmonomere, die sich für die Herstellung holographischer Medien, insbesondere zur visuellen Darstellung von Bildern eignen.

Photopolymere stellen Materialien dar, die mittels der Überlagerung zweier kohärenter Lichtquellen belichtet werden können, wobei sich eine dreidimensionale Struktur in den Photopolymeren ausbildet, die sich im allgemeinen durch eine regionale Änderung des Brechungsindexes in dem Material beschreiben lässt. Derartige Strukturen werden Hologramme genannt. Sie können auch als diffraktive optische Elemente beschrieben werden. Dabei hängt es von der speziellen Belichtung ab, welche optischen Funktionen ein solches Hologramm ausbildet.

Für die Anwendung von Photopolymeren als Träger von Hologrammen für optische Anwendungen im sichtbaren Bereich werden in der Regel nach der Belichtung farblose oder lediglich sehr schwach gefärbte Materialien mit einer hohen Beugungswirkung gefordert. Seit den Anfängen der Holographie werden Silberhalogenidfilme insbesondere diejenigen mit hohem Auflösungsvermögen hierfür verwendet. Auch Dichromatgelatine (DCG), Dichromatsalz-haltige Gelatinefilme, oder auch Mischformen aus Silberhalogenid und DCG werden verwendet. Beide Materialien benötigen eine chemische Nachbehandlung zur Bildung eines Hologramms, was für industrielle Prozesse zusätzliche Kosten erzeugt und den Umgang mit chemischen Entwicklerlösungen erforderlich macht. Zudem haben nasschemische Verfahren ein Quellen und später ein Schrumpfen des Filmes zufolge, was zu Farbverschiebungen in den Hologrammen führen kann, was unerwünscht ist.

US 4959284 (Dupont) beschreibt Photopolymere, die u.a. aus einem in organischen Lösungsmitteln löslichen Thermoplasten wie Polyvinylacetat, Celluloseacetobutyrat oder Polymethylmethacrylat-Styrol-Copolymere, einem Photoinitiator und mindestens einem Vinylcyclopropanderivat bestehen. In EP352774A1 (Dupont) werden zudem andere Vinylgruppen-haltigen Monomere beschrieben wie N-Vinylpyrrolidon, Phenoxyethylacrylat und Acrylester von Triolen wie Trimethylolpropan (TMPTA) und ethoxylierten Trimethylolpropan (TMPEOTA) oder andere Acrylester oder Acrylamide. Es ist in der Industrie bekannt, dass derartige Photopolymere erst nach einer längeren Temperaturbehandlung brauchbare Hologramme zeigen. O'Neill et al. (Applied Optics, Vol. 41, No.5, Seite 845ff., 2002) diskutieren in ihrem Übersichtsartikel neben den schon erwähnten Materialen auch noch Photopolymere, die aus Thermoplasten und Acrylamid erhältlich sind. Neben dem ungünstigen toxikologischen Profil von Acrylamid, zeigen derartige Produkte keine Hologramme mit hohem Brechungsindexkontrast.

Auch bekannt sind holographisch aktive Materialien, in denen Farbstoffe eingeblendet werden, die unter Lichteinfluss ihren Photoempfindlichkeit verändern (Luo et al, Optics Express, Vol. 13, No.8, 2005, Seite 3123). Ähnlich beschreibt Bieringer (Springer Series in Optical Sciences (2000), 76, Seite 209-228.) sog. photoadressierbare Polymere, die ebenfalls polymergebundene Farbstoffe sind, die unter Lichteinfluss isomerisiert werden können. In beide Substanzklassen kann man Hologramme einbelichten und diese Materialien zur holographischen Datenspeicherung verwenden. Allerdings sind diese Produkte naturgemäß stark gefärbt und damit nicht für die oben beschriebenen Anwendungen geeignet.

In jüngerer Zeit wurden zudem Photopolymere beschrieben, die nicht aus Thermoplasten, sondern aus vernetzten Polymeren erhalten werden: So ist in US 020070077498 (Fuji) 2,4,6-Tribromphenylacrylat beschrieben, das in einer Polyurethanmatrix gelöst ist. US 6103454 (InPhase) beschreibt ebenfalls eine Polyurethanmatrix mit polymerisierbaren Komponenten wie 4-Chlorphenylacrylat, 4-Bromstryrol und Vinylnaphthalen. Diese Formulierungen wurden für die holographische Datenspeicherung entwickelt, eine holographischen Anwendung, in der man viele, aber auch sehr schwache, nur mit elektronischen Detektoren lesbare Hologramme einschreibt und ausliest. Für optische Anwendungen im gesamten sichtbaren Bereich sind derartige Formulierungen nicht geeignet.

Aus der nicht vorveröffentlichten PCT-Anmeldung PCT/EP2008/002464 sind Formulierungen von Urethanacrylaten als Schreibmonomere in Polyurethanmatrizes bekannt. Sowohl die Schreibmonomere als auch deren Mengenbereiche sowie die möglichen Einsatzgebiete werden unspezifisch breit beschrieben.

Ausgehend von PCT/EP2008/002464 wurde nun gefunden, dass insbesondere dann für optische und Sicherheitsanwendungen sehr gut brauchbare farblose Hologramme mit hoher Beugungseffizienz erhalten werden können, wenn spezielle ungesättigte Urethane als Schreibmonomere verwendet werden und deren Mengenanteil in Bezug auf die Gesamtformulierung aus Matrixkomponenten und Schreibmonomeren wenigstens 10 Gew.-% beträgt.

Gegenstand der vorliegenden Erfindung sind daher Polyurethanzusammensetzungen umfassend eine Schreibmonomerkomponente a), enthaltend wenigstens 10 Gew.-% bezogen auf die Gesamtzusammensetzung eines oder mehrerer ungesättigter Urethane a) der Formeln (I) bis (III) als Schreibmonomere und polymere Verbindungen oder entsprechende Vorstufen als Matrix für die Schreibmonomere sowie ein Verfahren zur Herstellung von Medien, sowie die Medien selbst und ein Verfahren zur Aufzeichnung visueller Hologramme, bei dem eine solche Polyurethanzusammensetzung auf ein Substrat oder in eine Form appliziert und ausgehärtet wird.

Ebenfalls ein Gegenstand der Erfindung sind Urethanacrylate der Formel (II).

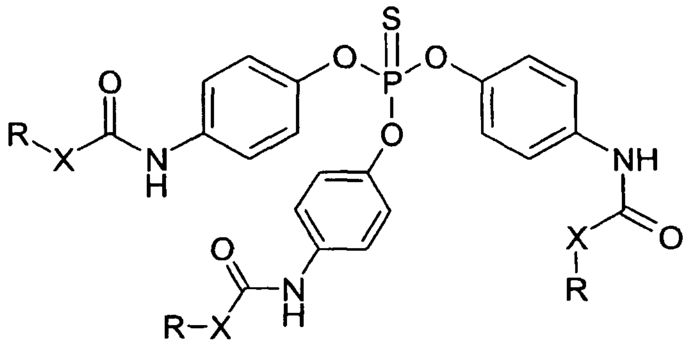

Formel (I)

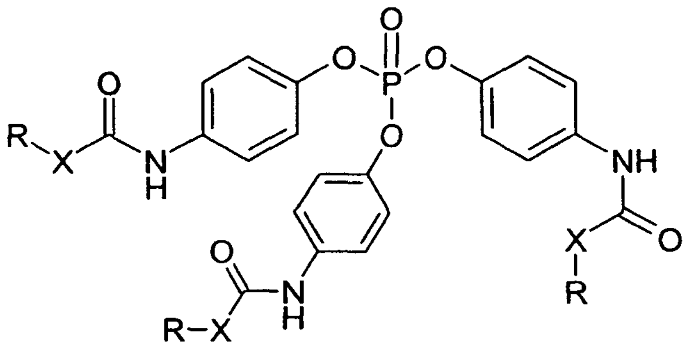

Formel (II)

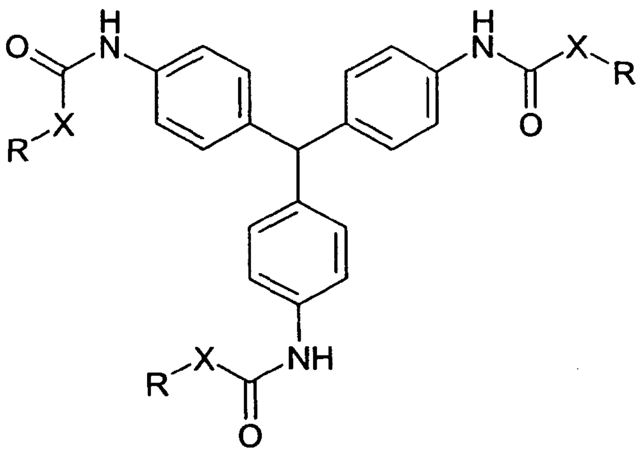

Formel (III)

wobei

R unabhängig voneinander jeweils eine strahlenhärtbare Gruppe und

X unabhängig voneinander jeweils eine Einfachbindung zwischen R und C=O oder ein linea- rer, verzweigter oder cyclischer gegebenenfalls heteroatomhaltiger und/oder gegebenen- falls durch funktionelle Gruppen substituierter Kohlenwasserstoffrest ist.

Strahlenhärtbare Gruppen im Sinne der vorliegenden Erfindung sind sämtliche funktionelle Gruppen, die unter Einwirkung aktinischer Strahlung mit olefinisch ungesättigten Verbindungen unter Polymerisation reagieren. Dies sind beispielsweise Vinylether- ($CH_2$=CH-O-), Maleinyl- (cis-HOOC-C=C-CO-O-), Fumaryl- (trans-HOOC-C=C-CO-O-), Maleinimid-, Dicyclopentadienyl-, Acrylamid- ($CH_2$=CH-(CO)-NH-), Methacrylamid- ($CH_2$=$CCH_3$-(CO)-NH-), Acrylat-

($CH_2$=CH-(CO)-O-) und Methacrylat-Gruppen ($CH_2$=$CCH_3$-(CO)-O-).

Unter aktinischer Strahlung wird elektromagnetische, ionisierende Strahlung verstanden, insbesondere Elektronenstrahlen, UV-Strahlen sowie sichtbares Licht (Roche Lexikon Medizin, 4.Auflage; Urban & Fischer Verlag, München 1999).

Bevorzugt ist R eine Vinylether-, Acrylat- oder Methacrylat-Gruppe, besonders bevorzugt eine Acrylatgruppe.

Grundsätzlich können einzelne oder mehrere der kohlenstoffgebundenen Wasserstoffatome der Gruppe R auch durch $C_1$- bis $C_5$-Alkylgruppen ersetzt sein, was allerdings nicht bevorzugt ist.

Bevorzugt weist die Gruppe X 2 bis 40 Kohlenstoffatome sowie ein oder mehrere in Form von Etherbrücken vorliegende Sauerstoffatome auf. X kann dabei sowohl linear als auch verzweigt oder cyclisch sowie durch funktionelle Gruppen substituiert sein. Besonders bevorzugt ist die Gruppe X jeweils eine lineare oder verzweigte Oxyalkylen- oder Polyoxyalkylengruppe.

Bevorzugte Polyoxyalkylengruppen weisen bis zu 10, besonders bevorzugt bis zu 8, Wiederholungseinheiten der jeweiligen Oxyalkylengruppe auf.

Grundsätzlich ist es möglich, dass X gleiche oder verschiedene Oxyalkylengruppen als Wiederholungseinheiten aufweist, wobei eine solche Wiederholungseinheit bevorzugt 2 bis 6, besonders bevorzugt 2 bis 4 Kohlenstoffatome aufweist. Besonders bevorzugte Oxyalkyleneinheiten sind Oxyethylen sowie jeweils die isomeren Oxypropylene oder Oxybutylene.

Die Wiederholungseinheiten innerhalb der jeweiligen Gruppe X können dabei ganz oder teilweise blockweise oder statistisch verteilt vorliegen.

In einer bevorzugten Ausführungsform der Erfindung ist X unabhängig voneinander jeweils eine Oxyalkyleneinheit ausgewählt aus der Gruppe bestehend aus $-CH_2-CH_2-O-$, $-CH_2CHCH_3-O-$, $-CHCH_3-CH_2-O-$, $-(CH_2-CH_2-O)_n-$, $-O(CH_2CHCH_3-O)_n-$ wobei n eine ganze Zahl von 2 bis 7 ist, und $-O-CH_2-CH_2-(O-(CH_2)_5-CO)_m-$, wobei m eine ganze Zahl von 1 bis 5 ist.

Die erfindungswesentlichen ungesättigten Urethane sind beispielsweise durch bevorzugt stöchiometrische Umsetzung der jeweils korrespondierenden Triisocyanate mit gleichen oder einer Mischung verschiedener Verbindungen der Formel R-X-H unter Addition erhältlich, wobei R und X die vorgenannte Bedeutung haben.

Als Triisocyanate werden Triphenylmethan-4,4',4"-triisocyanat, Tris(p-isocyanatophenyl)thiophosphat oder Tris(p-isocyanatophenyl)phosphat eingesetzt.

Als Verbindungen der Formel R-X-H werden beispielsweise hydroxyfunktionelle Acrylate oder Methacrylate wie 2-Hydroxyethyl(meth)acrylat, Polyethylenoxid-mono(meth)acrylate, Polypropylenoxidmono(meth)acrylate, Polyalkylenoxidmono(meth)acrylate, Poly(ε-caprolacton)mono-(meth)acrylate, wie z.B. Tone® M 100 (Dow, Schwalbach, Deutschland), Hydroxypropyl-(meth)acrylat, 4-Hydroxybutyl(meth)acrylat, 3-Hydroxy-2,2-dimethylpropyl(meth)acrylat, Hydroxypropyl(meth)acrylat oder deren technische Gemische eingesetzt.

Ebenfalls geeignete Verbindungen der Formel R-X-H sind hydroxylguppenhaltige Epoxy(meth)acrylate wie die Umsetzungsprodukte von Acrylsäure und/oder Methacrylsäure mit Epoxiden (Glycidylverbindungen). Bevorzugte Epoxyacrylate sind solche mit definierter Funktionalität wie sie aus der bekannten Umsetzung von Acrylsäure und/oder Methacrylsäure und Glycidyl(meth)acrylat erhalten werden können.

In einer bevorzugten Ausführungsform werden als Verbindungen der Formel R-X-H 2-Hydroxyethylacrylat, Hydroxypropylacrylat, 4-Hydroxybutylacrylat, Polyethylenoxidmono(meth)acrylat, Polypropylenoxidmono(meth)acrylat, Polyalkylenoxidmono(meth)acrylat, Poly(ε-caprolacton)-mono(meth)acrylat oder deren technische Gemische eingesetzt.

In einer besonders bevorzugten Ausführungsform werden als Verbindungen der Formel R-X-H 2-Hydroxyethylacrylat, Hydroxypropylacrylat, 4-Hydroxybutylacrylat oder deren Mischungen eingesetzt.

Ein Überschuss an Triisocyanat oder R-X-H gefolgt von einer anschließenden Abtrennung nicht zum Urethan umgesetzter Verbindungen ist denkbar, aufgrund der Polymerisationslabilität der Produkte nicht bevorzugt.

Die erfindungswesentlichen ungesättigten Urethane haben einen Gehalt an freien Isocyanatgruppen (M = 42) von unter 0.5 Gew.-%, bevorzugt unter 0.2 Gew.-%, besonders bevorzugt unter 0.1 Gew.-% sowie Gehalte an nicht umgesetzten Verbindungen R-X-H von unter 1 Gew.-%, bevorzugt unter 0.5 Gew.-% und besonders bevorzugt unter 0.2 Gew.-%.

Die Urethanbildung in der Additionsreaktion kann unter Zuhilfenahme der zur Beschleunigung von Isocyanatadditionsreaktionen bekannten Katalysatoren, wie z.B. tertiärer Amine, Zinn-, Zink-, Eisen- oder Bismutverbindungen, insbesondere Triethylamin, 1,4-Diazabicyclo-[2,2,2]-octan, Bismutoktoat oder Dibutylzinndilaurat erfolgen, die mit vorgelegt oder später zudosiert werden können.

Bei der Herstellung der erfindungswesentlichen ungesättigten Urethane oder anschließend können Stabilisatoren gegen ungewollte Polymerisation zugesetzt werden. Solche Stabilisatoren können sauerstoffhaltiges Gas sein wie auch chemische Stabilisatoren, wie sie beispielsweise in Houben-Weyl, Methoden der organischen Chemie, 4. Auflage, Band XIV/1, Georg Thieme Verlag, Stuttgart 1961, Seite 433 ff. beschrieben sind. Beispielsweise geeignete Stabilisatoren sind Natriumdithionit, Natriumhydrogensulfid, Schwefel, Hydrazin, Phenylhydrazin, Hydrazobenzol, N-Phenyl-β-naphthylamin, N-Phenyl-ethanoldiamin, Dinitrobenzol, Pikrinsäure, p-Nitroso-dimethylanilin, Diphenylnitrosamin, Phenole wie para-Methoxyphenol, 2,5-Di-tert.-butylhydrochinon, 2,6-Di-tert.-butyl-4-methylphenol, p-tert.-Butylbrenzcatechin oder 2,5-Di-tert.-amyl-hydrochinon, Tetramethyl-thiuramdisulfid, 2-Mercaptobenzothiazol, Dimethyl-dithiocarbaminsäure-natriumsalz, Phenothiazin, N-Oxyl-Verbindungen wie z.B. 2,2,6,6-Tetramethylpiperidin-N-Oxid (TEMPO) oder eines seiner Derivate.

Bevorzugte Stabilisatoren sind Phenothiazin, 2,6-Di-tert.-butyl-4-methylphenol und para-Methoxyphenol sowie deren Mischungen.

Solche Stabilisatoren werden typischerweise in einer Menge von 0.001 bis 1 Gew.-%, bevorzugt 0.01 bis 0.5 Gew. -% bezogen auf das zu stabilisierende ungesättigte Urethan eingesetzt.

Sollten die erfindungswesentlichen ungesättigten Urethane noch freie Isocyanatgruppen enthalten, so kann eine Stabilisierung durch geeignete Verbindungen wie Säuren oder Säurederivate, z.B. Benzoylchlorid, Phthaloylchlorid, phosphinige, phosphonige und/oder phosphorige Säure, Phosphin-, Phosphon- und/oder Phosphorsäure sowie die sauren Ester der letztgenannten 6 Säuretypen, Schwefelsäure und ihre sauren Ester und/oder Sulfonsäuren erfolgen.

Die Herstellung der erfindungswesentlichen ungesättigten Urethane kann in Anwesenheit gegenüber Edukten und Produkten inerter organischer Lösemittel durchgeführt werden. Beispiele sind Lacklösemittel wie Ethylacetat, Butylacetat, Solventnaphtha, Methoxypropylacetat, Aceton, Butanon oder Kohlenwasserstoffe wie Cyclohexan, Methylcyclohexan oder Isooctan.

Nach der Umsetzung kann das Lösemittel z.B. destillativ aus dem Produkt entfernt werden, im Produkt verbleiben oder gegen ein anderes Lösemittel ausgetauscht werden.

In einer bevorzugten Ausführung wird das Lösemittel nach der Umsetzung destillativ entfernt. In einer weiteren bevorzugten Ausführungsform wird nach der Umsetzung das Prozesslösemittel gegen ein anderes destillativ ausgetauscht. Dazu wird dieses andere Lösemittel nach der Umsetzung zugesetzt und das Prozesslösemittel destillativ entfernt. Voraussetzung für einen solchen Lösemitteltausch ist allerdings, dass das Prozesslösemittel einen niedrigeren Siedepunkt als das weitere Lösemittel aufweist.

Bei diesem weiteren Lösemittel handelt es sich bevorzugt um ein hydroxyfunktionelles Polymer (Polyol). Geeignete Polyole dieser Art sind Di- oder Polyole mit einem zahlenmittleren Molekulargewicht im Bereich von 500 bis 13000 g/mol, bevorzugt 700 bis 8500 g/mol.

Bevorzugte Polyole zu diesem Zweck besitzen eine mittlere Hydroxylfunktionalität von 1.5 bis 3.5, bevorzugt von 1.8 bis 3.2, besonders bevorzugt von 1.9 bis 3.1.

Solche Polyole der vorstehend genannten Art sind beispielsweise Polyesteralkohole auf Basis von aliphatischen, cycloaliphatischen und/oder aromatischen Di-, Tri- und/oder Polycarbonsäuren mit Di-, Tri-, und/oder polyfunktionellen Alkohlen sowie Polyesteralkohole auf Lacton-Basis.

Bevorzugte Polyesteralkohole mit einem Molekulargewicht bevorzugt von 500 bis 4000, besonders bevorzugt 650 bis 2500 g/mol sind z.B. Umsetzungsprodukte von Adipinsäure mit Hexandiol, Butandiol oder Neopentylglykol oder Mischungen der genannten Diole.

Ebenfalls geeignet sind Polyetherpolyole, die durch Polymerisation von cyclischen Ethern oder durch Umsetzung von Alkylenoxiden mit einem Startermolekül erhältlich sind.

Beispielhaft seien genannt die Polyethylen- und/oder Polypropylenglykole eines zahlenmittleren Molekulargewichts von 500 bis 13000 g/mol, weiterhin Polytetrahydrofurane eines zahlenmittleren Molekulargewichts von 500 bis 8000, bevorzugt von 650 bis 3000 g/mol.

Ebenfalls geeignet sind Polyester-Polyether-Polyester-Blockpolyole, die durch Umsetzung von Polyetherpolyolen mit Lactonen erhalten werden können.

Ebenfalls geeignet sind hydroxyl-terminierte Polycarbonate, die durch Umsetzung von Diolen oder auch Lacton-modifizierten Diolen oder auch Bisphenolen, wie z.B. Bisphenol A, mit Phosgen oder Kohlensäurediestem wie Diphenylcarbonat oder Dimethylcarbonat zugänglich sind.

Beispielhaft seien genannt die polymeren Carbonate des 1,6-Hexandiols eines zahlenmittleren Molekulargewichts von 500 bis 8000 g/mol, sowie die Carbonate von Umsetzungsprodukten des 1,6-Hexandiols mit ε-Caprolacton im molaren Verhältnis von 1 bis 0.1. Bevorzugte Carbonate sind vorgenannte Polycarbonatdiole eines zahlenmittleren Molekulargewichts von 650 bis 3000 g/mol auf Basis 1,6-Hexandiol und/oder Carbonate von Umsetzungsprodukten des 1,6-Hexandiols mit ε-Caprolacton im molaren Verhältnis von 1 bis 0.33.

Hydroxyl-terminierte Polyamidalkohole und Hydroxyl-terminierte Polyacrylatdiole, z.B. Tegomer® BD 1000 (Fa. Tego GmbH, Essen, Deutschland) sind ebenfalls einsetzbar.

Für den vorgenannten Lösemitteltausch als weiteres Lösemittel besonders geeignete Polyole sind Estergruppen-haltige Polyole und Polyetherpolyole der vorstehend genannten Art.

Die Herstellung der erfindungswesentlichen Urethane erfolgt entweder kontinuierlich z.B. in einem statischen Mischer oder diskontinuierlich z.B. in einem geeigneten Rührgefäß. Bei diskontinuierlicher Fahrweise kann sowohl Isocyanat als auch die Verbindungen R-X-H vorgelegt werden und die jeweils andere Komponente bei Raumtemperatur oder erhöhter Temperatur zudosiert werden. Bevorzugt erfolgt die Umsetzung, indem die Isocyanatkomponente vorgelegt und R-X-H zudosiert werden.

Bei Verwendung einer Mischung verschiedener Verbindungen der Formel R-X-H können diese sowohl in Form einer Mischung oder sequenziell in beliebiger Reihenfolge zugegeben werden, wobei bevorzugt ist, die Verbindungen R-X-H in der Reihenfolge ansteigender Reaktivität gegenüber dem Isocyanaten zuzugeben.

Die bevorzugte Reaktionstemperatur beträgt 40 °C bis 130 °C, besonders bevorzugt 50 °C bis 80 °C. Die Temperatur wird durch externes Heizen und/oder geeignetes Ausnutzen der freiwerdenden Reaktionswärme eingestellt.

Der Fortgang der Umsetzung von NCO und OH-Gruppen zum Urethan kann spektroskopisch z.B. durch Aufnahme von Infrarot- oder Nahinfrarotspektren oder durch chemische Analysen an entnommenen Proben durchgeführt werden.

Insbesondere eignet sich z.B. der Isocyanat- gegebenenfalls auch der Hydroxylgehalt als Maß für den Umsatz der Reaktion.

Die erfindungswesentlichen Urethane haben in lösemittelfreier Form typischerweise eine Doppelbindungsdichte bezogen auf die strahlenhärtbaren Gruppen, bevorzugt Acrylat- und Methacrylatgruppen von ≥0.5, bevorzugt ≥0.8 mol C=C pro kg des Urethans.

Die erfindungsgemäßen Polyurethanzusammensetzungen weisen in Komponente a) bevorzugt mindestens 10 Gew.-%, besonders bevorzugt wenigstens 15 Gew.-% und ganz besonders bevorzugt mindestens 20 Gew.-% bezogen auf die Polyurethanzusammensetzungen an den erfindungswesentlichen ungesättigten Urethanen a) als Schreibmonomere auf. Der Anteil dieser Schreibmonomere a) an der Gesamtformulierung beträgt jedoch bevorzugt nicht mehr als 70 Gew.-%, besonders bevorzugt nicht mehr als 50 Gew.-%.

Die erfindungsgemäßen Polyurethanzusammensetzungen weisen neben der Schreibmonomerkomponente a) polymere Verbindungen als Matrix für die Schreibmonomere oder entsprechende Matrix Vorstufen auf, aus denen sich die entsprechende Matrix für die Schreibmonomere ausbildet.

Bevorzugt enthalten die erfindungsgemäßen Polyurethanzusammensetzungen als Aufbaukomponenten für die Matrix

eine Isocyanatkomponente b)
eine Isocyanat-reaktive Komponente c)
sowie einen oder mehrere Photoinitiatoren d).

Die Isocyanatkomponente b) umfasst bevorzugt Polyisocyanate. Als Polyisocyanate können alle dem Fachmann an sich gut bekannten Verbindungen oder deren Mischungen eingesetzt werden, die im Mittel zwei oder mehr NCO-Funktionen pro Molekül aufweisen. Diese können auf aromatischer, araliphatischer, aliphatischer oder cycloaliphatischer Basis sein. In untergeordneten Mengen können auch Monoisocyanate und/oder ungesättigte Gruppen enthaltende Polyisocyanate mitverwendet werden.

Beispielsweise geeignet sind Butylendiisocyanat, Hexamethylendiisocyanat (HDI), Isophorondiisocyanat (IPDI), 1,8-Diisocyanato-4-(isocyanatomethyl)-octan, 2,2,4- und/oder 2,4,4-Trimethylhexamethylendiisocyanat, die isomeren Bis-(4,4'-isocyanatocyclohexyl)methan und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat und/oder Triphenylmethan-4,4',4"-triisocyanat.

Ebenfalls möglich ist der Einsatz von Derivaten monomerer Di- oder Triisocyanate mit Urethan-, Harnstoff-, Carbodiimid-, Acylharnstoff-, Isocyanurat-, Allophanat-, Biuret-, Oxadiazintrion-, U-retdion- und/oder Iminooxadiazindionstrukturen.

Bevorzugt ist der Einsatz von Polyisocyanaten auf Basis aliphatischer und/oder cycloaliphatischer Di- oder Triisocyanate.

Besonders bevorzugt handelt es sich bei den Polyisocyanaten der Komponente b) um di- oder oligomerisierte aliphatische und/oder cycloaliphatische Di- oder Triisocyanate.

Ganz besonders bevorzugt sind Isocyanurate, Uretdione und/oder Iminooxadiazindione basierend auf HDI, 1,8-Diisocyanato-4-(isocyanatomethyl)-oktan oder deren Mischungen.

Als Komponente c) können an sich alle polyfunktionellen, isocyanatreaktiven Verbindungen eingesetzt werden, die im Mittel wenigstens 1.5 isocyanatreaktive-Gruppen pro Molekül aufweisen.

Isocyanatreaktive Gruppen im Rahmen der vorliegenden Erfindung sind bevorzugt Hydroxy-, Amino- oder Thiogruppen, besonders bevorzugt sind Hydroxyverbindungen.

Geeignete polyfunktionelle, isocyanatreaktive Verbindungen sind beispielsweise Polyester-, Polyether-, Polycarbonat-, Poly(meth)acrylat- und/oder Polyurethanpolyole.

Als Polyesterpolyole sind beispielsweise lineare Polyesterdiole oder verzweigte Polyesterpolyole geeignet, wie sie in bekannter Weise aus aliphatischen, cycloaliphatischen oder aromatischen Di- bzw. Polycarbonsäuren bzw. ihren Anhydriden mit mehrwertigen Alkoholen einer OH-Funktionalität ≥2 erhalten werden.

Beispiele für solche Di- bzw. Polycarbonsäuren bzw. Anhydride sind Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebige Gemische untereinander.

Beispiele für solche geeigneten Alkohole sind Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12, Trimethylolpropan, Glycerin oder deren beliebige Gemische untereinander.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen wie Butyrolacton, ε-Caprolacton und/oder Methyl-ε-caprolacton an hydroxyfunktionelle Verbindungen wie mehrwertige Alkohole einer OH-Funktionalität ≥ 2 beispielsweise der vorstehend genannten Art erhalten werden können.

Solche Polyesterpolyole haben bevorzugt zahlenmittlere Molmassen von 400 bis 4000 g/Mol, besonders bevorzugt von 500 bis 2000 g/Mol. Ihre OH-Funktionalität beträgt bevorzugt 1.5 bis 3.5, besonders bevorzugt 1.8 bis 3.0.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkoholen einer OH-Funktionalität ≥ 2, bevorzugt 1,4-Butandiol; 1,6-Hexandiol und/oder 3-Methylpentandiol, oder auch Polyesterpolyole können zu Polycarbonatpolyolen umgearbeitet werden.

Solche Polycarbonatpolyole haben bevorzugt zahlenmittlere Molmassen von 400 bis 4000 g/Mol, besonders bevorzugt von 500 bis 2000 g/Mol. Die OH-Funktionalität dieser Polyole beträgt bevorzugt 1.8 bis 3.2, besonders bevorzugt 1.9 bis 3.0.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können die an sich im Rahmen der Polyesterpolyole genannten mehrwertigen Alkohole einer OH-Funktionalität ≥2 sowie primäre oder sekundäre Amine und Aminoalkohole verwendet werden.

Solche Polyetherpolyole haben bevorzugt zahlenmittlere Molmassen von 250 bis 10000 g/Mol, besonders bevorzugt von 500 bis 8500 g/Mol und ganz besonders bevorzugt von 600 bis 4500 g/Mol. Die OH-Funktionalität beträgt bevorzugt 1.5 bis 4.0, besonders bevorzugt 1.8 bis 3.0.

Daneben sind als Bestandteile der Komponente c) als polyfunktionelle, isocyanatreaktive Verbindungen auch niedermolekulare, d.h. mit Molekulargewichten kleiner 500 g/mol, kurzkettige, d.h. 2 bis 20 Kohlenstoffatome enthaltende aliphatische, araliphatische oder cycloaliphatische di-, tri- oder polyfunktionelle Alkohole geeignet.

Dies können beispielsweise sein Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsäure (2,2-dimethyl-3-hydroxypropylester). Beispiele geeigneter Triole sind Trimethylolethan, Trimethylolpropan oder Glycerin. Geeignete höherfunktionelle Alkohole sind Ditrimethylolpropan, Pentaerythrit, Dipentaerythrit oder Sorbit.

Als Komponente d) werden ein oder mehrere Photoinitiatoren eingesetzt. Dies sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ I) und bimolekularen (Typ II) Initiatoren unterschieden wird. Desweiteren werden diese Initiatoren je nach chemischer Natur für die radikalische, die anionische (oder), die kationische (oder gemischte) Formen der vorgenannten Polymerisationen eingesetzt.

(Typ I)-Systeme für die radikalische Photopolymerisation sind z.B. aromatische Ketonverbindungen, z.B. Benzophenone in Kombination mit tertiären Aminen, Alkylbenzophenone, 4,4'-Bis(dimethylamino)benzophenon (Michlers Keton), Anthron und halogenierte Benzophenone oder Mischungen der genannten Typen. Weiter geeignet sind (Typ II)-Initiatoren wie Benzoin und seine Derivate, Benzilketale, Acylphosphinoxide z.B. 2,4,6-Trimethyl-benzoyl-diphenylphosphinoxid, Bisacyclophosphinoxid, Phenylglyoxylsäureester, Campherchinon, alpha-Aminoalkylphenon, alpha-,alpha-Dialkoxyacetophenon, 1-[4-(Phenylthio)phenyl]octan-1,2-dion-2-(O-benzoyloxim) und alpha-Hydroxyalkylphenon. Auch die in EP-A 0223587 beschriebenen Photoinitiatorsysteme bestehend aus einer Mischung aus einem Ammoniumarylborat und einem oder mehreren Farbstoffen können als Photoinitiator eingesetzt werden. Als Ammoniumarylborat eignen sich beispielsweise Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat $Ph_3B^{\theta}Bu$, $(Napht)_3B^{\theta}Bu$. Als Farbstoffe eignen sich beispielsweise Neu-Methylenblau, Thionin, Basic Yellow, Pinacynol Chlorid, Rhodamin 6G, Gallocyanin, Ethylviolett,

Victoria Blue R, Celestine Blue, Chinaldinrot, Kristallviolett, Brilliant Grün, Astrazon Orange G, Darrow Red, Pyronin Y, Basic Red 29, Pyrillium I, Cyanin und Methylenblau, Azur A (Cunningham et al., RadTech'98 North America UV/EB Conference Proceedings, Chicago, Apr. 19-22, 1998).

Die für die anionische Polymerisation verwendeten Photoinitiatoren sind in der Regel (Typ I)-Systeme und leiten sich von Übergangsmetall-Komplexen der ersten Reihe ab. Hier sind ChromSalze, wie z.B. trans-$Cr(NH_3)_2(NCS)_4^-$ (Kutal et al, Macromolecules 1991, 24, 6872) oder Ferrocenyl-Verbindungen (Yamaguchi et al. Macromolecules 2000, 33, 1152) bekannt. Eine weitere Möglichkeit der anionischen Polymerisation besteht in der Verwendung von Farbstoffen, wie Kristallviolett Leukonitril oder Malchit Grün Leukonitril, die durch photolytischen Zerfall Cyanoacrylate polymerisieren können (Neckers et al. Macromolecules 2000, 33, 7761). Allerdings wird dabei das Chromophor in das Polymer eingebaut, so dass die resultierenden Polymere durchgefärbt sind.

Die für die kationische Polymerisation verwendeten Photoinitiatoren bestehen im wesentlichen aus drei Klassen: Aryldiazonium-Salze, Onium-Salze (hier speziell: Iodonium-, Sulfonium- und Selenonium-Salze) sowie Organometall-Verbindungen. Phenyldiazonium-Salze können unter Bestrahlung sowohl in Gegenwart als auch in Abwesenheit eines Wasserstoff-Donors ein Kation erzeugen, das die Polymerisation initiiert. Die Effizienz des Gesamtsystems wird durch die Natur des verwendeten Gegenions zur Diazonium-Verbindung bestimmt. Bevorzugt sind hier die wenig reaktiven aber recht teuren $SbF_6^-$, $AsF_6^-$ oder $PF_6^-$. Für den Einsatz in Beschichtung dünner Filme sind diese Verbindungen i.d.R wenig geeignet, da durch den nach der Belichtung freigesetzten Stickstoff die Oberflächegüte herabgesetzt wird (pinholes) (Li et al., Polymeric Materials Science and Engineering, 2001, 84, 139). Sehr weit verbreitet und auch in vielerlei Form kommerziell erhältlich sind Onium-Salze, speziell Sulfonium- und Iodonium-Salze. Die Photochemie dieser Verbindungen ist nachhaltig untersucht worden. Die Iodonium-Salze zerfallen nach der Anregung zunächst homolytisch und erzeugen somit ein Radikal und ein Radikalkation, welches sich durch H-Abstraktion stabilisiert, ein Proton freisetzt und dann die kationische Polymerisation startet (Dektar et al. J. Org. Chem. 1990, 55, 639; J. Org. Chem., 1991, 56. 1838). Dieser Mechanismus ermöglicht den Einsatz von Iodonium-Salzen ebenfalls für die radikalische Photopolymerisation. Hierbei kommt erneut der Wahl des Gegenions eine große Bedeutung zu, bevorzugt werden ebenfalls die recht teuren $SbF_6^-$, $AsF_6^-$ oder $PF_6^-$. Ansonsten ist in dieser Strukturklasse die Wahl der Substitution des Aromaten recht frei und im wesentlichen durch die Verfügbarkeit geeigneter Startbausteine für die Synthese bestimmt. Bei den Sulfonium-Salzen handelt es sich um Verbindungen, die nach Norrish(II) zerfallen (Crivello et al., Macromolecules, 2000, 33, 825). Auch bei den Sulfonium-Salzen kommt der Wahl des Gegenions eine kritische Bedeutung zu, die sich im Wesentlichen in der Härtungsgeschwindigkeit der Polymere äußert. Die besten Ergebnisse werden i.d.R. mit $SbF_6^-$ Salzen erzielt. Da die Eigenabsorption von Iodonium- und Sulfonium-Salze bei <300nm liegt, müssen diese Verbindungen für die Photopolymerisation mit nahem UV oder kurzwelligem sichtbarem Licht entsprechend sensibilisiert werden. Dies gelingt durch die Verwendung von höher absorbierenden Aromaten wie z.B. Anthracen und Derivaten (Gu et al., Am. Chem. Soc. Polymer Preprints, 2000, 41 (2), 1266) oder Phenothiazin bzw. dessen Derivaten (Hua et al, Macromolecules 2001, 34, 2488-2494).

Es kann vorteilhaft sein auch Gemische dieser Verbindungen einzusetzen. Je nach zur Härtung verwendeter Strahlungsquelle muss Typ und Konzentration an Photoinitiator in dem Fachmann bekannter Weise angepasst werden. Die vorgenannte Einstellung hinsichtlich der Photopolymerisation ist für einen Fachmann in Form von Routineversuchen innerhalb der unten angegebenen Mengenbereiche der Komponenten sowie der jeweils zur Auswahl stehenden, insbesondere den bevorzugten Aufbaukomponenten, leicht möglich.

Bevorzugte Photoinitiatoren d) sind Mischungen aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin.

Neben den Komponenten a) bis d) können auch Radikalstabilisatoren, Katalysatoren und weitere Zusatzstoffe mit eingesetzt werden.

Als Radikalstabilisatoren geeignet sind Inhibitoren und Antioxidantien wie sie in "Methoden der organischen Chemie" (Houben-Weyl), 4. Auflage, Band XIV/1, S. 433ff, Georg Thieme Verlag, Stuttgart 1961, beschrieben sind. Geeignete Stoffklassen sind beispielsweise Phenole wie z.B. 2,6-Di-tert-butyl-4-methylphenol, Kresole, Hydrochinone, Benzylalkohole wie z.B. Benzhydrol, ggf. auch Chinone wie z. B. 2,5-Di-tert.-Butylchinon, ggf. auch aromatische Amine wie Diisopropylamin oder Phenothiazin. Bevorzugte Radikalstabilisatoren sind 2,6-Di-tert.-butyl-4-methylphenol, Phenothiazin und Benzhydrol.

Ferner können ein oder mehrere Katalysatoren eingesetzt werden. Diese katalysieren bevorzugt die Urethanbildung. Dazu sind bevorzugt Amine sowie Metallverbindungen der Metalle Zinn, Zink, Eisen, Bismuth, Molybdän, Kobalt, Calzium, Magnesium und Zirkonium geeignet. Besonders bevorzugt sind Zinnoctoat, Zinkoktoat, Dibutylzinndilaurat, Dimethylzinndicarboxylat, Eisen(III)-acetylacetonat, Eisen(II)-chlorid, Zinkchlorid, Tetra-alkyl-ammoniumhydroxide, Alkalihydroxide, Alkalialkoholate, Alkalisalze von langkettigen Fettsäuren mit 10 bis 20 Kohlenstoffatomen und gegebenenfalls seitenständigen OH-Gruppen, Bleioctoat oder tertiäre Amine wie Triethylamin, Tributylamin, Dimethylbenzylamin, Dicyclohexylmethylamin, Dimethyl-cyclohexylamin, N,N,N',N'-Tetramethyl-diamino-diethylether, Bis-(dimethylamino-propyl)-harnstoff, N-Methyl- bzw. N-Ethylmorpholin, N,N'-Dimorpholinodiethylether (DMDEE), N-Cyclohexylmorpholin, N,N,N',N'-Tetramethylethylendiamin, N,N,N',N'-Tetramethyl-butan-diamin, N,N,N',N'-Tetramethylhexandiamin-1,6, Pentamethyldiethylentriamin, Dimethylpiperazin, N-Dimethylaminoethylpiperidin, 1,2-Dimethylimidazol, N-Hydroxypropylimidazol, 1-Azabicyclo-(2,2,0)-octan, 1,4-Diazabicyclo-(2,2,2)-octan (Dabco) oder Alkanolaminverbindungen, wie Triethanolamin, Triisopropanolamin, N-Methyl- und N-Ethyl-diethanolamin, Dimethyl-amino-ethanol, 2-(N,N-Dimethylaminoethoxy)ethanol oder N-Tris-(dialkylaminoalkyl)hexa-hydro-triazine, z.B. N,N',N-Tris-(dimethylaminopropyl)-s-hexahydrotriazin, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Besonders bevorzugte Katalysatoren sind Dibutylzinndilaurat, Dimethylzinndicarboxylat, Eisen(III)acetylacetonat, 1,4-Diazabicyclo-[2.2.2]-octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Als weitere Hilfs- und Zusatzstoffe können beispielsweise enthalten sein Lösemittel, Weichmacher, Verlaufsmittel, Benetzungsmittel, Entschäumer oder Haftvermittler, aber auch Polyurethane, thermoplastische Polymere, Oligomere, weitere funktionelle Gruppen, wie z.B. Acetale, Epoxid, Oxetane, Oxazoline, Dioxolane und/oder hydrophile Gruppen, wie z.B. Salze und/oder Polyethylenoxide, aufweisende Verbindungen.

Als Lösemittel werden dabei bevorzugt leichtflüchtige Lösemittel mit guter Verträglichkeit mit den erfindungsgemäßen 2-Komponentenformulierungen verwendet, beispielsweise Ethylacetat, Butylacetat und/oder Aceton.

Als Weichmacher werden dabei bevorzugt Flüssigkeiten mit guten Löseeigenschaften, geringer Flüchtigkeit und hoher Siedetemperatur eingesetzt. Es kann auch von Vorteil sein, gleichzeitig mehrere Zusatzstoffe eines Typs zu verwenden. Selbstverständlich kann es ebenfalls von Vorteil sein, mehrere Zusatzstoffe mehrerer Typen zu verwenden.

Bevorzugt umfassen die erfindungsgemäßen Polyurethanzusammensetzungen

10 bis 94.999 Gew.-% der erfindungswesentlichen ungesättigten Urethane der Formeln (I) bis (III) als Komponente a)

5 bis 89.999 Gew.-% der Komponenten b) und c) oder der entsprechenden Umsetzungsprodukte von b) mit c),

0.001 bis 10 Gew.-% Photoinitiatoren d),

0 bis 10 Gew.-% Radikalstabilisatoren

0 bis 4 Gew.-% Katalysatoren

0 bis 70 Gew.-% Hilfs- und Zusatzstoffe.

Besonders bevorzugt umfassen die erfindungsgemäßen Polyurethanzusammensetzungen

15 bis 70 Gew.-% der erfindungswesentlichen ungesättigten Urethane der Formeln (I) bis (III) als Komponente a)

10 bis 84.899 Gew.-% der Komponenten b) und c) oder der entsprechenden Umsetzungsprodukte von b) mit c),

0.1 bis 7.5 Gew.-% Photoinitiatoren d),

0.001 bis 1 Gew.-% Radikalstabilisatoren

0 bis 3 Gew.-% Katalysatoren

0 bis 50 Gew.-% Hilfs- und Zusatzstoffe.

Besonders bevorzugt umfassen die erfindungsgemäßen Polyurethanzusammensetzungen

20 bis 50 Gew.-% der erfindungswesentlichen ungesättigten Urethane der Formeln (I) bis (III) als Komponente a)

25 bis 79.489 Gew.-% der Komponenten b) und c) oder der entsprechenden Umsetzungsprodukte von b) mit c),

0.5 bis 5 Gew.-% Photoinitiatoren d),

0.01 bis 0.5 Gew.-% Radikalstabilisatoren

0.001 bis 2 Gew.-% Katalysatoren

0 bis 35 Gew.-% Hilfs- und Zusatzstoffe.

Die Komponenten b) und c) werden dabei in einem OH/NCO-Verhältnis zueinander eingesetzt von typischerweise 0.5 bis 2.0, bevorzugt 0.95 bis 1.50, besonders bevorzugt 0.97 bis 1.33.

Das erfindungsgemäße Verfahren zur Herstellung von Medien zur Aufzeichnung visueller Hologramme wird bevorzugt derart durchgeführt, dass die Aufbaukomponenten der erfmdungsgemäßen Polyurethanzusammensetzungen mit Ausnahme der Komponente b) miteinander homogen vermischt werden und unmittelbar vor der Applikation auf das Substrat oder in die Form erst Komponente b) zugemischt wird.

Zur Vermischung können alle dem Fachmann aus der Mischungstechnik an sich bekannten Verfahren und Apparate, wie beispielsweise Rührkessel oder sowohl dynamische als auch statische Mischer verwendet werden. Bevorzugt sind allerdings Apparate ohne oder mit nur geringen Toträumen. Weiterhin sind Verfahren bevorzugt, in denen die Vermischung innerhalb sehr kurzer Zeit und mit sehr starker Durchmischung der beiden zu mischenden Komponenten erfolgt. Hierfür eignen sich insbesondere dynamische Mischer, insbesondere solche, in denen die Komponenten erst im Mischer miteinander in Kontakt kommen.

Die Temperaturen betragen dabei 0 bis 100 °C, bevorzugt 10 bis 80 °C, besonders bevorzugt 20 bis 60 °C, ganz besonders bevorzugt 20 bis 40°C.

Falls notwendig kann auch eine Entgasung der einzelnen Komponenten oder der gesamten Mischung unter einem reduzierten Druck von beispielsweise 1 mbar durchgeführt werden. Ein Entgasen, insbesondere nach Zugabe der Komponente b) ist bevorzugt, um Blasenbildung durch Restgase in den erhältlichen Medien zu verhindern.

Vor Zumischung der Komponente b) können die Mischungen als lagerstabiles Zwischenprodukt gegebenenfalls über mehrere Monate gelagert werden kann.

Nach der Zumischung der Komponente b) der erfindungsgemäßen Polyurethanzusammensetzungen wird eine klare, flüssige Formulierung erhalten, die je nach Zusammensetzung bei Raumtemperatur innerhalb weniger Sekunden bis zu einigen Stunden aushärtet.

Das Verhältnis sowie die Art und Reaktivität der Aufbaukomponenten der Polyurethanzusammensetzungen wird bevorzugt so eingestellt, dass die Aushärtung nach Zumischung der Komponente b) bei Raumtemperatur innerhalb von Minuten bis zu einer Stunde eintritt. In einer bevorzugten Ausführungsform wird die Aushärtung beschleunigt indem die Formulierung nach der Zumischung auf Temperaturen zwischen 30 und 180 °C, bevorzugt 40 bis 120 °C, besonders bevorzugt 50 bis 100 °C erwärmt wird.

Die vorgenannte Einstellung hinsichtlich des Aushärteverhaltens ist für einen Fachmann in Form von Routineversuchen innerhalb der oben angegebenen Mengenbereich der Komponenten sowie der jeweils zur Auswahl stehenden, insbesondere den bevorzugten Aufbaukomponenten, leicht möglich.

Die erfindungsgemäßen Polyurethanzusammensetzungen besitzen unmittelbar nach vollständiger Vermischung aller Komponenten Viskositäten bei 25°C von typischerweise 10 bis 100000 mPas, bevorzugt 100 bis 20000 mPas, besonders bevorzugt 200 bis 15000 mPas, insbesondere bevorzugt 500 bis 10000 mPas so dass sie bereits in lösemittelfreier Form sehr gute verarbeitungstechnische Eigenschaften besitzen. In Lösung mit geeigneten Lösemitteln können Viskositäten bei 25°C unterhalb 10000 mPas, bevorzugt unterhalb 2000 mPas, besonders bevorzugt unterhalb 500 mPas eingestellt werden.

Als vorteilhaft haben sich Polyurethanzusammensetzungen der vorstehend genannten Art erwiesen, die in einer Menge von 15 g und mit einem Katalysatorgehalt von 0.004 Gew.-% bei 25°C unter 4 Stunden aushärten, bzw. bei einem Katalysatorgehalt von 0.02 % in weniger als 10 Minuten bei 25°C aushärten.

Zur Applikation auf ein Substrat bzw. in eine Form sind alle jeweiligen gängigen, dem Fachmann bekannten Verfahren geeignet, wie insbesondere Rakeln, Gießen, Drucken, Siebdruck, Spritzen, oder Inkjet-Druck.

Mit den erfindungsgemäßen Polyurethanzusammensetzungen können durch entsprechende Belichtungsprozesse Hologramme für optische Anwendungen im gesamten sichtbaren und nahen UV-Bereich (300-800 nm) hergestellt werden. Visuelle Hologramme umfassen alle Hologramme, die nach dem Fachmann bekannten Verfahren aufgezeichnet werden können, darunter fallen unter anderem In-Line (Gabor) Hologramme, Off-Axis Hologramme, Full-Aperture Transfer Hologramme, Weißlicht-Transmissionshologramme ("Regenbogenhologramme), Denisyukhologramme, Off-Axis Reflektionshologramme, Edge-Lit Hologramme sowie Holographische Stereogramme, bevorzugt sind Reflexionshologramme, Denisyukhologramme, Transmissionshologramme. Bevorzugt sind optische Elemente wie Linsen, Spiegel, Umlenkspiegel, Filter, Streuscheiben, Beugungselemente, Lichtleiter, Lichtlenker (waveguides), Projektionsscheiben und/oder Masken. Häufig zeigen diese optischen Elemente eine Frequenzselektivität je nachdem wie die Hologramme belichtet wurden und welche Dimensionen das Holgramm hat.

Zudem können mittels der erfindungsgemäßen Polyurethanzusammensetzungen auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellten Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendung dar.

Ein weiterer Gegenstand der vorliegenden Erfindung ist daher die Verwendung der erfindungsgemäßen Medien zur Aufzeichnung visueller Hologramme und zur Herstellung von optischen Elementen, Bildern, Darstellungen sowie ein Verfahren zur Aufzeichnung von Hologrammen unter Verwendung der erfindungsgemäßen Medien.

**Beispiele:**

Die folgenden Beispiele sind zur Erläuterung der erfindungsgemäßen Photopolymere genannt, sollen aber nicht als begrenzend verstanden sein. Sofern nicht abweichend vermerkt beziehen sich alle Prozentangaben auf Gewichtsprozent.

**Beispiele 1:**

In einem 500 mL Rundkolben wurden 0.1 g 2,6-Di-tert.-butyl-4-methylphenol, 0.05 g Dibutylzinndilaurat (Desmorapid Z, Bayer MaterialScience AG, Leverkusen, Deutschland) sowie 213.07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

**Beispiel 2:**

In einem 250 mL Rundkolben wurden 0.03 g 2,6-Di-tert.-butyl-4-methylphenol, 0.05 g Dibutylzinndilaurat sowie 150.34 g einer 27 %-igen Lösung von Tris(p-isocyanatophenyl)thiophosphat in Ethylacetat vorgelegt und auf 60 °C erwärmt. Anschließend wurden 14.95 g 2-Hydroxyethylacrylat zugetropft und die Mischung weiter auf 60 °C gehalten, bis der Isocyanatgehalt unter 3.3 % gesunken war. Anschließend wurden 44.33 g Poly(ε-caprolacton)monoacrylate (Tone M100, Produkt der Dow Chemicals Inc.) zugetropft und weiter so lange auf 60 °C gehalten, bis der Isocyanatgehalt unter 0.1 % gesunken war. Danach wurde abgekühlt und im Vakuum das Ethylacetat vollständig entfernt. Das Produkt wurde als viskose Flüssigkeit erhalten.

**Beispiel 3:**

In einem 500 mL Rundkolben wurden 0.1 g 2,6-Di-tert.-butyl-4-methylphenol, 0.05 g Dibutylzinndilaurat sowie 189.52 g einer 27 %-igen Lösung von Triphenylmethan-4,4',4"-triisocyanat in Ethylacetat vorgelegt und auf 65 °C erwärmt. Anschließend wurden 48.68 g 2-Hydroxyethylacrylat zugetropft und die Mischung weiter auf 65 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

**Beispiel 4:**

In einem 500 mL Rundkolben wurden 0.06 g 2,6-Di-tert.-butyl-4-methylphenol, 0.03 g Desmorapid Z sowie 122.6 g einer 27 %-igen Lösung von Tris(p-isocyanatophenyl)thiophosphat in Ethylacetat vorgelegt und auf 60 °C erwärmt. Anschließend wurden 27.3 g Hydroxypropylacrylat zugetropft und die Mischung weiter auf 60 °C gehalten, bis der Isocyanatgehalt unter 0.1 % gesunken war. Danach wurde abgekühlt und das Ethylacetat im Vakuum vollständig entfernt. Das Produkt wurde als hellgelbe Flüssigkeit erhalten.

**Beispiel 5:**

In einem 500 mL Rundkolben wurden 0.06 g 2,6-Di-tert.-butyl-4-methylphenol, 0.03 g Desmorapid Z, 120.2 g einer 27 %-igen Lösung von Tris(p-isocyanatophenyl)thiophosphat in Ethylacetat vorgelegt und auf 60 °C erwärmt. Anschließend wurden 29.7 g 4-Hydroxybutylacrylat zugetropft und die Mischung weiter auf 60 °C gehalten, bis der Isocyanatgehalt unter 0.1 % gesunken war. Danach wurde abgekühlt und das Ethylacetat im Vakuum vollständig entfernt. Das Produkt wurde als hellgelbe Flüssigkeit erhalten.

**Beispiel 6:**

In einem 500 mL Rundkolben wurden 0.07 g 2,6-Di-tert.-butyl-4-methylphenol, 0.04 g Desmorapid Z, 109.1 g einer 27 %-igen Lösung von Tris(p-isocyanatophenyl)thiophosphat in Ethylacetat vorgelegt und auf 60 °C erwärmt. Anschließend wurden 40.8 g Polyethylenglycolmonomethacrylat (PEM3, Fa. LAPORTE Performance Chemicals UK LTD) zugetropft und die Mischung weiter auf 60 °C gehalten, bis der Isocyanatgehalt unter 0.1 % gesunken war. Danach wurde abgekühlt und das Ethylacetat im Vakuum vollständig entfernt. Das Produkt wurde als hellgelbe Flüssigkeit erhalten.

**Herstellung der Polyol-Komponente:**

In einem 1 L Kolben wurden 0.18 g Zinnoktoat, 374.81 g ε-Caprolacton und 374.81 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

**Vergleichsmedium 1:**

7.61 g der wie oben beschrieben hergestellten Polyol-Komponente wurden mit 0.50 g Urethanacrylat aus Beispiel 1, 0.10 g CGI 909 (CGI 909 ist ein im Jahr 2008 von der Fa. Ciba Inc., Basel, Schweiz vertriebenes Versuchsprodukt) und 0.01 g Neu Methylenblau, 0.35 g N-Ethylpyrrolidon und 0.02 g Glasperlen 20 μm bei 50 °C gemischt, so dass eine klare Lösung erhalten wurde. Anschließend wurde auf 30 °C abgekühlt, 1.41 g Desmodur® XP 2410 (Versuchsprodukt der Bayer MaterialScience AG, Leverkusen, Deutschland, Hexandiisocyanat-basiertes Polyisocyanat, Anteil an Iminooxadiazindion mindestens 30 %, NCO-Gehalt: 23.5 %) zugegeben und erneut gemischt. Schließlich wurden 0.006 g Fomrez UL 28 (Urethanisierungskatalysator, Handelsprodukt der Fa. Momentive Performance Chemicals, Wilton, CT, USA) zugegeben und erneut kurz gemischt. Die erhaltene, flüssige Masse wurde dann auf eine Glasplatte gegeben und dort mit einer zweiten Glasplatte abgedeckt. Dieser Probenkörper wurde 12 Stunden unter 15 kg Gewichten bei Raumtemperatur gehärtet.

**Medium 1:**

7.19 g der wie oben beschrieben hergestellten Polyol-Komponente wurden mit 1.00 g Urethanacrylat aus Beispiel 1, 0.10 g CGI 909 und 0.01 g Neu Methylenblau, 0.35 g N-Ethylpyrrolidon und 0.02 g Glasperlen 20 μm bei 50 °C gemischt, so dass eine klare Lösung erhalten wurde. Anschließend wurde auf 30 °C abgekühlt, 1.33 g Desmodur® XP 2410 zugegeben und erneut gemischt. Schließlich wurden 0.009 g Formrez UL 28 zugegeben und erneut kurz gemischt. Die erhaltene, flüssige Masse wurde dann auf eine Glasplatte gegeben und dort mit einer zweiten Glasplatte abgedeckt. Dieser Probenkörper wurde 12 Stunden unter 15 kg Gewichten bei Raumtemperatur gehärtet.

**Medium 2:**

6.98 g der wie oben beschrieben hergestellten Polyol-Komponente wurden mit 1.25 g Urethanacrylat aus Beispiel 1, 0.10 g CGI 909 und 0.01 g Neu Methylenblau, 0.35 g N-Ethylpyrrolidon und 0.02 g Glasperlen 20 μm bei 50 °C gemischt, so dass eine klare Lösung erhalten wurde. Anschließend wurde auf 30 °C abgekühlt, 1.29 g Desmodur® XP 2410 zugegeben und erneut gemischt. Schließlich wurden 0.009 g Formrez UL 28 zugegeben und erneut kurz gemischt. Die erhaltene, flüssige Masse wurde dann auf eine Glasplatte gegeben und dort mit einer zweiten Glasplatte abgedeckt. Dieser Probenkörper wurde 12 Stunden unter 15 kg Gewichten bei Raumtemperatur gehärtet.

**Medium 3:**

8.75 g der wie oben beschrieben hergestellten Polyol-Komponente wurden mit 3.75 g Urethanacrylat aus Beispiel 1, 0.15 g CGI 909 und 0.015 g Neu Methylenblau, 0.52 g N-Ethylpyrrolidon und 0.02 g Glasperlen 20 μm bei 50 °C gemischt, so dass eine klare Lösung erhalten wurde. Anschließend wurde auf 30 °C abgekühlt, 1.647 g Desmodur® XP 2410 zugegeben und erneut gemischt. Schließlich wurden 0.009 g Formrez UL 28 zugegeben und erneut kurz gemischt. Die erhaltene, flüssige Masse wurde dann auf eine Glasplatte gegeben und dort mit einer zweiten Glasplatte abgedeckt. Dieser Probenkörper wurde 12 Stunden unter 15 kg Gewichten bei Raumtemperatur gehärtet.

**Medium 4:**

6.54 g der wie oben beschrieben hergestellten Polyol-Komponente wurden mit 1.77 g Urethanacrylat aus Beispiel 2, 0.10 g CGI 909 und 0.01 g Neu Methylenblau, 0.35 g N-Ethylpyrrolidon und 0.015 g Glasperlen 17 µm bei 50 °C gemischt, so dass eine klare Lösung erhalten wurde. Anschließend wurde auf 30 °C abgekühlt, 1.21 g Desmodur® XP 2410 zugegeben und erneut gemischt. Schließlich wurden 0.006 g Formrez UL 28 zugegeben und erneut kurz gemischt. Die erhaltene, flüssige Masse wurde dann auf eine Glasplatte gegeben und dort mit einer zweiten Glasplatte abgedeckt. Dieser Probenkörper wurde 12 Stunden unter 15 kg Gewichten bei Raumtemperatur gehärtet.

**Medium 5:**

5.92 g der wie oben beschrieben hergestellten Polyol-Komponente wurden mit 2.50 g Urethanacrylat aus Beispiel 4, 0.10 g CGI 909 und 0.01 g Neu Methylenblau, 0.35 g N-Ethylpyrrolidon und 0.015 g Glasperlen 20 µm bei 50 °C, gemischt, so dass eine klare Lösung erhalten wurde. Anschließend wurde auf 30 °C abgekühlt, 1.10 g Desmodur® XP 2410 zugegeben und erneut gemischt. Schließlich wurden 0.006 g Formrez UL 28 zugegeben und erneut kurz gemischt. Die erhaltene, flüssige Masse wurde dann auf eine Glasplatte gegeben und dort mit einer zweiten Glasplatte abgedeckt. Dieser Probenkörper wurde 12 Stunden unter 15 kg Gewichten bei Raumtemperatur gehärtet.

**Medium 6:**

5.92 g der wie oben beschrieben hergestellten Polyol-Komponente wurden mit 2.50 g Urethanacrylat aus Beispiel 5, 0.10 g CGI 909 und 0.01 g Neu Methylenblau, 0.35 g N-Ethylpyrrolidon und 0.015 g Glasperlen 20 µm bei 50 °C, gemischt, so dass eine klare Lösung erhalten wurde. Anschließend wurde auf 30 °C abgekühlt, 1.10 g Desmodur® XP 2410 zugegeben und erneut gemischt. Schließlich wurden 0.006 g Formrez UL 28 zugegeben und erneut kurz gemischt. Die erhaltene, flüssige Masse wurde dann auf eine Glasplatte gegeben und dort mit einer zweiten Glasplatte abgedeckt. Dieser Probenkörper wurde 12 Stunden unter 15 kg Gewichten bei Raumtemperatur gehärtet.

**Medium 7:**

5.92 g der wie oben beschrieben hergestellten Polyol-Komponente wurden mit 2.50 g Urethanacrylat aus Beispiel 6, 0.10 g CGI 909 und 0.01 g Neu Methylenblau, 0.35 g N-Ethylpyrolidon und 0.015 g Glasperlen 20 µm bei 50 °C gemischt, so dass eine klare Lösung erhalten wurde. Anschließend wurde auf 30 °C abgekühlt, 1.10 g Desmodur® XP 2410 zugegeben und erneut gemischt. Schließlich wurden 0.006 g Formrez UL 28 zugegeben und erneut kurz gemischt. Die erhaltene, flüssige Masse wurde dann auf eine Glasplatte gegeben und dort mit einer zweiten Glasplatte abgedeckt. Dieser Probenkörper wurde 12 Stunden unter 15 kg Gewichten bei Raumtemperatur gehärtet.

Figur 1 zeigt den holographischen Versuchsaufbau, mit dem die Beugungseffizienz (DE) der Medien gemessen wurde. Die wie beschrieben hergestellten Medien wurden anschließend wie folgt auf ihre holographischen Eigenschaften geprüft:

Der Strahl eines HeNe Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 4 mm. Die polarisationsabhängigen Strahlteiler (PBS) teilen den Laserstrahl in zwei kohärente gleich polarisierte Strahlen. Über die $\lambda/2$ Plättchen wurden die Leistung des Referenzstrahls auf 0.5 mW und die Leistung des Signalstrahls auf 0.65 mW eingestellt. Die Leistungen wurden mit den Halbleiterdetektoren (D) bei ausgebauter Probe bestimmt. Der Einfallswinkel ($\alpha$) des Referenzstrahls beträgt 21.8°, der Einfallswinkel ($\beta$) des Signalstrahl beträgt 41.8°. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand im Medium beträgt ~225 nm (Brechungsindex des Mediums zu ~1.49 angenommen).

Es wurden auf folgende Weise Hologramme in das Medium geschrieben: Beide Shutter (S) sind für die Belichtungszeit t geöffnet.

Danach wurde bei geschlossenen Shuttern (S) dem Medium 5 Minuten Zeit für die Diffusion der noch nicht polymerisierten Schreibmonomere gelassen.

Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde-auf einen Durchmesser < 1 mm geschlossen. Damit erreichte man, dass für alle Drehwinkel ($\Omega$) des Mediums der Strahl immer vollständig im zuvor geschriebenen Hologramm lag. Der Drehtisch überstrich nun computergesteuert den Winkelbereich von $\Omega = 0°$ bis $\Omega = 20°$ mit einer Winkelschrittweite von 0.05°. An jedem angefahrenen Winkel $\Omega$ wurden die Leistungen des in der nullten Ordnung transmittierten Strahls mittels des entsprechenden Detektors D und die Leistungen des in

die erste Ordnung abgebeugten Strahls mittels des Detektors D gemessen. Die Beugungseffizienz ergab sich bei jedem angefahrenen Winkel Ω als der Quotient aus:

$$\text{Leistung im Detektor des abgebeugten Strahls} / (\text{Leistung im Detektor des abgebeugten Strahls} + \text{Leistung im Detektor des transmittierten Strahls})$$

Die maximale Beugungseffizienz (DE) des Hologramms, also sein Spitzenwert, wurde ermittelt. Eventuell musste dazu die Position des Detektors des abgebeugten Strahls verändert werden, um diesen maximalen Wert zu bestimmen.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis E ergibt sich wie folgt:

$$E\ (\mathrm{mJ/cm^2}) = 2 \cdot [(0.50\ \mathrm{mW} + 0.67\ \mathrm{mW}) \cdot t\ (\mathrm{s})]/[\pi \cdot 0.4^2\ \mathrm{cm^2}]$$

Dabei ergaben sich folgende Messwerte für DE bei der Dosis E:

| Beispiel | Urethanacrylat | Gehalt an Urethanacrylat in Gew.% | Dosis ($mJ/cm^2$) | DE [%] |
|---|---|---|---|---|
| Vergleichsmedium | Beispiel 1 | 5 | 4.56 | 11 |
| Medium 1 | Beispiel 1 | 10 | 4.56 | 52 |
| Medium 2 | Beispiel 1 | 12.5 | 4.56 | 57 |
| Medium 3 | Beispiel 1 | 25 | 4.56 | 88 |
| Medium 4 | Beispiel 2 | 17.7 | 12.5 | 77 |
| Medium 5 | Beispiel 4 | 25 | 4.56 | 69 |
| Medium 6 | Beispiel 5 | 25 | 4.56 | 85 |
| Medium 7 | Beispiel 6 | 25 | 4.56 | 60 |

Der für die holographischen Medien im oben beschriebenen Experiment erhaltene Beugungswirkungsgrad DE sollte sinnvollerweise größer 50% betragen, da dann mindestens die Hälfte des einfallenden Lichtes abgebeugt wird. Dies führt zu im gesamten sichtbaren Bereich nutzbaren, hellen und kontrastreichen Hologrammen im Sinne der obigen Beschreibung.

Die gefundenen Werte für den Beugungswirkungsgrad DE und die notwendige Dosis zeigen, dass die auf den erfindungsgemäßen Urethanacrylaten basierenden Photopolymere, bei denen der Urethanacrylat-Gehalt größer oder gleich 10 Gewichtsprozent beträgt, als holographische Medien im Sinne der obigen Beschreibung sehr gut geeignet sind. Besonders gute holographische Medien können erhalten werden, wenn der Gehalt an Urethanacrylat größer oder gleich 15 Gewichtsprozente beträgt.

## Patentansprüche

1. Polyurethanzusammensetzungen umfassend eine Schreibmonomerkomponente a) enthaltend wenigstens 10 Gew.-% bezogen auf die Gesamtzusammensetzung eines oder mehrerer ungesättigter Urethane a) der Formeln (I) bis (III) als Schreibmonomere und polymere Verbindungen oder entsprechende Matrix Vorstufen als Matrix für die Schreibmonomere

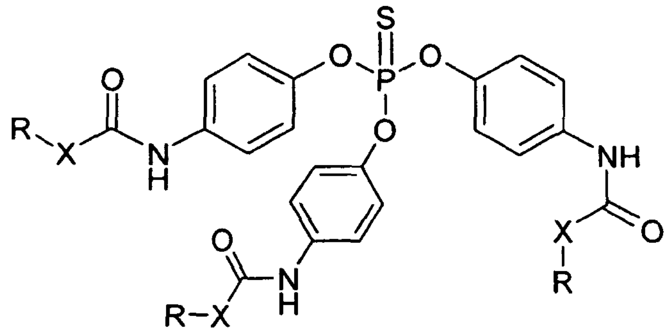

Formel (I)

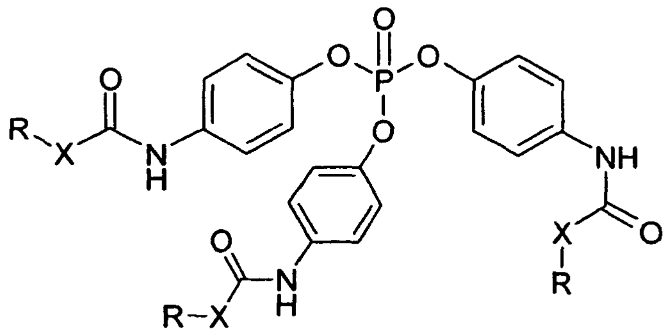

Formel (II)

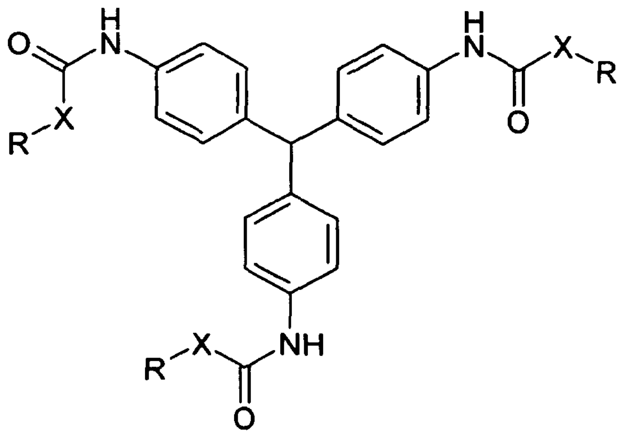

Formel (III)

wobei

R unabhängig voneinander jeweils eine strahlenhärtbare Gruppe und
X unabhängig voneinander jeweils eine Einfachbindung zwischen R und C=O oder ein line- arer, verzweigter oder cyclischer gegebenenfalls heteroatomhaltiger und/oder gegebenen- falls durch funktionelle Gruppen substituierter Kohlenwasserstoffrest ist.

**2.** Polyurethanzusammensetzungen gemäß Anspruch 1, **dadurch gekennzeichnet, dass** in den Formeln (I) bis (III) R eine Vinylether-, Acrylat- oder Methacrylat-Gruppe ist.

**3.** Polyurethanzusammensetzungen gemäß Anspruch 1 oder 2, **dadurch gekennzeichnet, dass** in den Formeln (I) bis (III) die Gruppe X jeweils eine lineare oder verzweigte Oxyalkylen- oder Polyoxyalkylengruppe ist.

4. Polyurethanzusammensetzungen gemäß einem der Ansprüche 1 bis 3, **dadurch gekennzeichnet, dass** die Schreibmonomere a) bezogen auf die Gesamtformulierung in Mengen von 20 bis 50 Gew.-% vorliegen.

5. Polyurethanzusammensetzungen gemäß einem der Ansprüche 1 bis 4, **dadurch gekennzeichnet, dass** diese als Aufbaukomponenten für die Matrix
eine Isocyanatkomponente b)
eine Isocyanat-reaktive Komponente c)
sowie einen oder mehrere Photoinitiatoren d) umfassen.

6. Verfahren zur Herstellung von Medien geeignet zur Aufzeichnung visueller Hologramme, bei dem Polyurethanzusammensetzungen gemäß einem der Ansprüche 1 bis 5 auf ein Substrat oder in eine Form appliziert und ausgehärtet werden.

7. Verfahren gemäß Anspruch 6, **dadurch gekennzeichnet, dass** zunächst eine Mischung der Komponenten der Polyurethanzusammensetzungen bereitgestellt wird und die Komponente b) erst abschließend unmittelbar vor der Applikation zugemischt wird.

8. Medien geeignet zur Aufzeichnung visueller Hologramme erhältlich nach einem Verfahren gemäß Anspruch 6 oder 7.

9. Verwendung von Medien gemäß Anspruch 8 zur Aufzeichnung visueller Hologramme oder zur Herstellung von optischen Elementen, Bildern, Darstellungen.

10. Verfahren zur Aufzeichnung von Hologrammen, bei dem Medien gemäß Anspruch 8 mittels Laserstahl belichtet werden.

## Claims

1. Polyurethane compositions comprising a writing monomer component a) containing at least 10% by weight, based on the total composition, of one or more unsaturated urethanes a) of the formulae (I) to (III) as writing monomers and polymeric compounds or corresponding matrix precursors as a matrix for the writing monomers

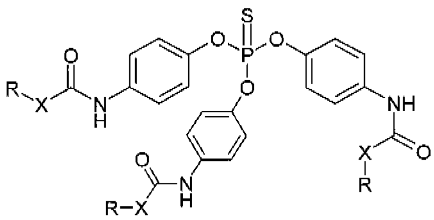

Formula (I)

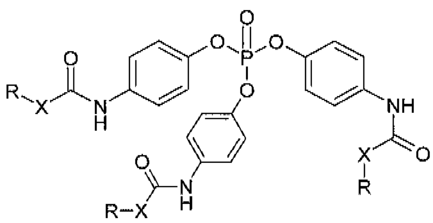

Formula (II)

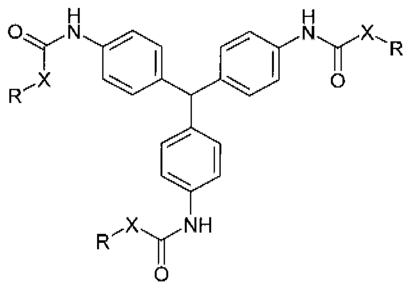

Formula (III)

in which

R, independently of one another, is in each case a radiation-curable group and
X, independently of one another, is in each case a single bond between R and C=O or a linear, branched or cyclic hydrocarbon radical which optionally contains heteroatoms and/or is optionally substituted by functional groups.

2. Polyurethane compositions according to claim 1, **characterized in that**, in the formulae (I) to (III), R is a vinyl ether, acrylate or methacrylate group.

3. Polyurethane compositions according to Claim 1 or 2, **characterized in that**, in the formulae (I) to (III), the group x is in each case a linear or branched oxyalkylene or, polyoxyalkylene group.

4. Polyurethane compositions according to any of Claims 1 to 3, **characterized in that** the writing monomers a) are present in amounts of 20 to 50% by weight, based on the total formulation.

5. Polyurethane compositions according to any of Claims 1 to 4, **characterized in that** they comprise, as synthesis components of the matrix,
an isocyanate component b) an isocyanate-reactive component c)
and one or more photoinitiators d).

6. Process for the production of media suitable for recording visual holograms, in which polyurethane compositions according to any of Claims 1 to 5 are applied to a substrate or in a mould and are cured.

7. Process according to Claim 6, **characterized in that** first a mixture of the components of the polyurethane compositions is provided and the component b) is admixed only finally immediately before the application.

8. Media suitable for recording visual holograms obtainable by a process according to Claim 6 or 7.

9. Use of media according to Claim 8 for recording visual holograms or for the production of optical elements, images, displays.

10. Method for recording holograms, in which media according to Claim 8 are exposed by means of a laser beam.

**Revendications**

1. Compositions de polyuréthane comprenant un composant monomère d'enregistrement a) contenant au moins 10% en poids, par rapport à la composition totale, d'un ou de plusieurs uréthanes insaturés a) des formules (I) à (III) comme monomères d'enregistrement et des composés polymères ou des précurseurs de matrice correspondants comme matrice pour les monomères d'enregistrement

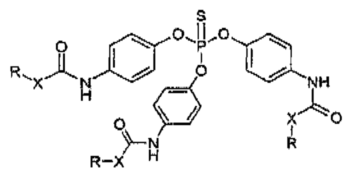

Formule (I)

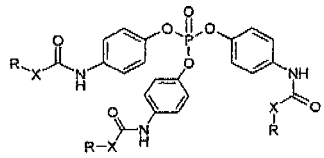

Formule (II)

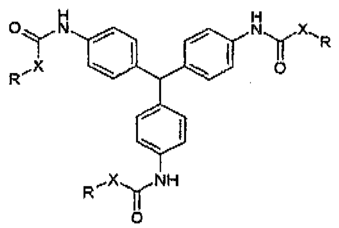

Formule (III)

où

R représente, indépendamment l'un de l'autre, à chaque fois un groupe durcissant sous l'effet de rayons et X représenté, indépendamment l'un de l'autre, à chaque fois une simple liaison entre R et C=O ou un radical hydrocarboné linéaire, ramifié ou cyclique, contenant le cas échéant des hétéroatomes et/ou le cas échéant substitué par des groupes fonctionnels.

**2.** Compositions de polyuréthane selon la revendication 1, **caractérisées en ce que** dans les formules (I) à (III) R représente un groupe vinyléther, acrylate ou méthacrylate.

**3.** Compositions de polyuréthane selon la revendication 1 ou 2, **caractérisées en ce que** dans les formules (I) à (III), le groupe X représente à chaque fois un groupe oxyalkylène ou polyoxyalkylène linéaire ou ramifié.

**4.** Compositions de polyuréthane selon l'une quelconque des revendications 1 à 3, **caractérisées en ce que** les monomères d'enregistrement a) se trouvent en des quantités de 20 à 50% en poids par rapport à la formulation totale.

**5.** Compostions de polyuréthane selon l'une quelconque des revendications 1 à 4, **caractérisées en ce qu'**elles comprennent, comme composants constitutif pour la matrice
un composant isocyanate b)
un composant réactif avec isocyanate c) ainsi qu'un ou plusieurs photo-initiateurs d).

**6.** Procédé pour la fabrication d'agents appropriés pour enregistrer des hologrammes visuels, dans lequel des compositions de polyuréthane selon l'une quelconque des revendications 1 à 5 sont appliquées sur un substrat ou dans un moule et durcies.

**7.** Procédé selon la revendication 6, **caractérisé en ce qu'**on prépare d'abord un mélange des composants des compositions de polyuréthane et le composant b) n'est mélangé qu'à la fin, juste avant l'application.

**8.** Agents appropriés pour enregistrer des hologrammes visuels pouvant être obtenus selon un procédé selon la revendication 6 ou 7.

**9.** Utilisation d'agents selon la revendication 8 pour enregistrer des hologrammes visuels ou pour la fabrication d'éléments, d'écrans, de représentations optiques.

**10.** Procédé pour enregistrer des hologrammes, dans lequel des agents selon la revendication 8 sont éclairés par un rayon laser.

Fig. 1

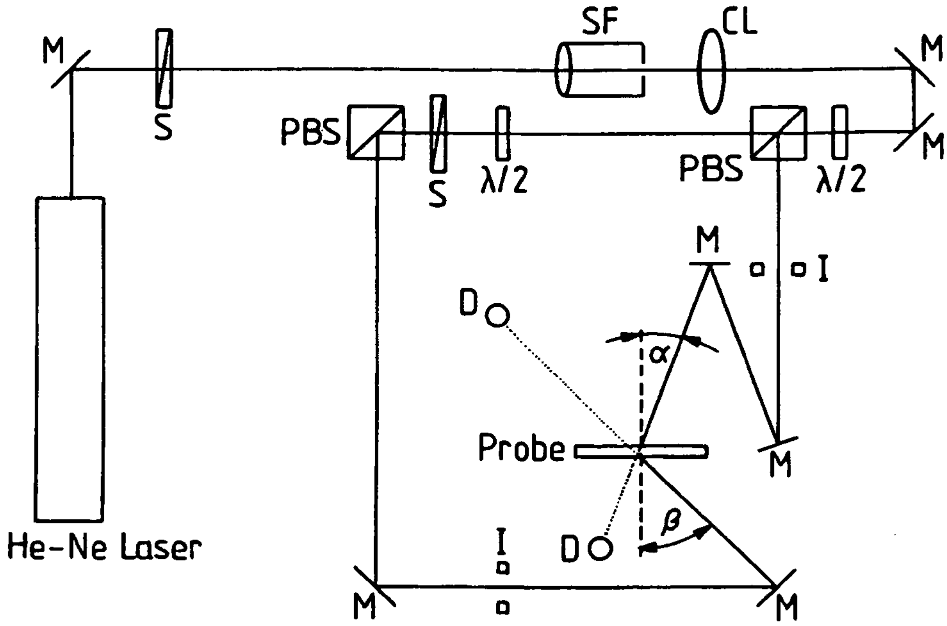

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4959284 A, Dupont
- EP 352774 A1, Dupont
- US 020070077498 A
- US 6103454 A
- EP 2008002464 W
- EP 0223587 A


### In der Beschreibung aufgeführte Nicht-Patentliteratur


- **O'Neill et al.** *Applied Optics,* 2002, vol. 41 (5), 845ff
- **Luo et al.** *Optics Express,* 2005, vol. 13 (8), 3123
- *Springer Series in Optical Sciences,* 2000, vol. 76, 209-228
- Roche Lexikon Medizin. Urban & Fischer Verlag, 1999
- **Houben-Weyl.** Methoden der organischen Chemie. Georg Thieme Verlag, 1961, vol. XIV/1, 433 ff
- **Cunningham et al.** *RadTech'98 North America UV/EB Conference Proceedings,* 19. April 1998
- **Kutal et al.** *Macromolecules,* 1991, vol. 24, 6872
- **Yamaguchi et al.** *Macromolecules,* 2000, vol. 33, 1152
- **Neckers et al.** *Macromolecules,* 2000, vol. 33, 7761
- **Li et al.** *Polymeric Materials Science and Engineering,* 2001, vol. 84, 139
- **Dektar et al.** *J. Org. Chem.,* 1990, vol. 55, 639
- *J. Org. Chem.,* 1991, vol. 56., 1838
- **Crivello et al.** *Macromolecules,* 2000, vol. 33, 825
- **Gu et al.** *Am. Chem. Soc. Polymer Preprints,* 2000, vol. 41 (2), 1266
- **Hua et al.** *Macromolecules,* 2001, vol. 34, 2488-2494
- Methoden der organischen Chemie. Georg Thieme Verlag, 1961, vol. XIV/1, 433ff